# EUROPEAN PATENT APPLICATION

(11) **EP 4 618 129 A2**
(43) Date of publication of application: **17.09.2025**
(21) Application number: 25163389.7
(22) Date of filing: 13.03.2025
(51) Int. Cl.: H01J 37/067

(54) **CHARGED PARTICLE BEAM SYSTEM AND REPLACEMENT METHOD FOR CHARGED PARTICLE SOURCE UNIT**

(30) Priority: 14.03.2024 JP 2024040250
(71) Applicant: JEOL Ltd., Akishima-shi, Tokyo 196-8558 (JP)
(72) Inventor: IKEDA, Yuta, Tokyo, 196-8558 (JP); ARIMA, Norikazu, Tokyo, 196-8558 (JP); YAMAZAKI, Yuji, Tokyo, 196-8558 (JP); MATSUZAKI, Mizuki, Tokyo, 196-8558 (JP); NOMURA, Takumi, Tokyo, 196-8558 (JP); ICHIKAWA, Katsunori, Tokyo, 196-8558 (JP); YOSHIDA, Takuya, Tokyo, 196-8558 (JP); SATO, Hiroyuki, Tokyo, 196-8558 (JP); OYAMA, Yoshiki, Tokyo, 196-8558 (JP)
(74) Representative: Boult Wade Tennant LLP

(57) **Abstract**

A charged particle beam system includes: a chamber (202); a charged particle source unit that has a charged particle source (210); a supporting member (700) that is provided on a side wall of the chamber and detachably supports the charged particle source unit inside the chamber; and a chamber door (204) that is provided on the side wall of the chamber for access to an interior of the chamber.

## Description

### BACKGROUND OF THE INVENTION

### Field of the Invention

The present invention relates to a charged particle beam system and a replacement method for a charged particle source unit.

### Description of Related Art

In charged particle beam systems such as transmission electron microscopes, scanning electron microscopes, and focused ion beam systems, charged particle beams are emitted from a charged particle source. The charged particle source needs to be replaced regularly because of service life thereof. For example, JP S52-98462 A discloses a replacement method for a filament that serves as the electron source of an electron microscope.

In such charged particle beam systems, it is desirable for the charged particle source to be easily replaceable.

### SUMMARY OF THE INVENTION

According to a first aspect of the present disclosure, there is provided a charged particle beam system including:
a chamber;
a charged particle source unit that has a charged particle source;
a supporting member that is provided on a side wall of the chamber and detachably supports the charged particle source unit inside the chamber; and
a chamber door that is provided on the side wall of the chamber for access to an interior of the chamber.

According to a second aspect of the present disclosure, there is provided a replacement method for a charged particle source unit in a charged particle beam system that includes:
a chamber;
a charged particle source unit that has a charged particle source;
a supporting member that is provided on a side wall of the chamber and detachably supports the charged particle source unit inside the chamber; and
a chamber door that is provided on the side wall of the chamber for access to an interior of the chamber,
the replacement method including:
   opening the chamber door;
   removing a first charged particle source unit from the supporting member; and
   introducing a second charged particle source unit into the chamber through the chamber door and attaching the second charged particle source unit to the supporting member.

### BRIEF DESCRIPTION OF THE DRAWINGS

FIG. 1 is a diagram illustrating an example of a configuration of a transmission electron microscope.
FIG. 2 is a perspective view schematically illustrating a housing.
FIG. 3 is a front elevation schematically illustrating a transmission electron microscope.
FIG. 4 is a perspective view schematically illustrating a housing with a housing door opened.
FIG. 5 is a perspective view schematically illustrating an electron gun chamber.
FIG. 6 is a perspective view schematically illustrating an electron gun chamber.
FIG. 7 is a perspective view schematically illustrating an electron gun chamber.
FIG. 8 is a perspective view schematically illustrating a bottom of an electron gun chamber.
FIG. 9 is a cross-sectional perspective view schematically illustrating a filament unit.
FIG. 10 is an exploded perspective view schematically illustrating a filament unit.
FIG. 11 is a perspective view schematically illustrating a state where a filament unit is being attached to an attachment part of a supporting member.
FIG. 12 is a perspective view schematically illustrating a state where a filament unit has been attached to an attachment part of a supporting member.
FIG. 13 is a perspective view schematically illustrating a state where a filament unit has been attached to an attachment part of a supporting member.
FIG. 14 illustrates a locking mechanism that fixes a filament unit to a supporting member.
FIG. 15 is a flowchart illustrating an example of a replacement method for a filament unit.
FIG. 16 is a perspective view schematically illustrating a jig.
FIG. 17 is a perspective view schematically illustrating a jig.
FIG. 18 is a perspective view schematically illustrating a step of removing a first filament unit.
FIG. 19 is a perspective view schematically illustrating a step of attaching a second filament unit.
FIG. 20 is a flowchart illustrating an example of a boosting process performed by a controller.
FIG. 21 is a flowchart illustrating an example of a start process performed by a controller.
FIG. 22 is a diagram illustrating a power supply circuit that applies an accelerating voltage.
FIG. 23 is a diagram illustrating a power supply circuit in a case where a discharge occurs.
FIG. 24 is a flowchart illustrating an example of an automatic boosting process as part of a start function performed by the controller.
FIG. 25 is a diagram illustrating an example of boosting and step-down operations for an accelerating voltage.

### DESCRIPTION OF THE INVENTION

According to an embodiment of the present disclosure, there is provided a charged particle beam system including:
a chamber;
a charged particle source unit that has a charged particle source;
a supporting member that is provided on a side wall of the chamber and detachably supports the charged particle source unit inside the chamber; and
a chamber door that is provided on the side wall of the chamber for access to an interior of the chamber.

In the charged particle beam system described above, it is possible to extract or introduce the charged particle source unit through the chamber door provided on the side wall of the chamber. Therefore, it is easier to replace the charged particle source unit.

According to an embodiment of the present disclosure, there is provided a replacement method for a charged particle source unit in a charged particle beam system that includes:
a chamber;
a charged particle source unit that has a charged particle source;
a supporting member that is provided on a side wall of the chamber and detachably supports the charged particle source unit inside the chamber; and
a chamber door that is provided on the side wall of the chamber for access to an interior of the chamber,
the replacement method including:
   opening the chamber door;
   removing a first charged particle source unit from the supporting member; and
   introducing a second charged particle source unit into the chamber through the chamber door and attaching the second charged particle source unit to the supporting member.

In the replacement method for the charged particle source unit described above, it is possible to extract the first charged particle source unit or introduce the second charged particle source unit through the chamber door provided on the side wall of the chamber. Therefore, it is easier to replace the charged particle source unit.

Preferred embodiments of the invention will be described in detail below with reference to the drawings. Note that the following embodiments do not unduly limit the content of the invention described in the claims. Furthermore, all the following components described below are not necessarily essential requirements of the invention.

Furthermore, the following description will illustrate the case where the charged particle beam system according to the invention is a transmission electron microscope that includes a filament as a charged particle source and generates an electron beam from the filament. However, the charged particle beam system according to the invention may also be a device in which a charged particle source generates a charged particle beam (such as an ion beam) other than an electron beam.

### 1. Transmission Electron Microscope

### 1.1. Configuration of Transmission Electron Microscope

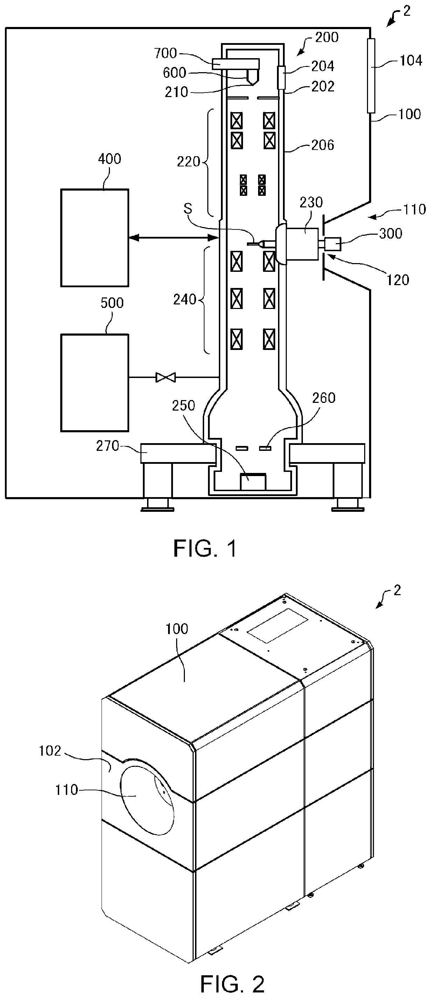

First, a transmission electron microscope according to an embodiment of the invention will be described with reference to the drawings. FIG. 1 illustrates an example of the configuration of a transmission electron microscope 2 according to an embodiment of the invention.

As illustrated in FIG. 1, the transmission electron microscope 2 includes a housing 100, a body portion 200, a sample holder 300, a controller 400, and a vacuum pumping system 500.

The housing 100 accommodates the body portion 200, the controller 400, and the vacuum pumping system 500. Note that the housing 100 may accommodate only the body portion 200. The housing 100 has a housing door 104 that is provided for access to an electron gun chamber 202.

The body portion 200 includes: an electron source 210; an illumination optical system 220 that illuminates a sample S with electrons emitted from the electron source 210; a holder support portion 230 with an insertion port that enables the insertion and extraction of the sample holder 300; an imaging optical system 240 that forms an image with the electrons that have passed through the sample S; an imager 250 that captures a transmission electron microscope image (TEM image) formed by the electrons that have passed through the sample S, and a detector 260 that obtains a scanning transmission electron microscope image (STEM image) by detecting the electrons that have passed through the sample S.

The electron source 210 is accommodated in the electron gun chamber 202. The electron source 210 is, for example, a tungsten filament and constitutes an electron gun that emits an electron beam. A filament unit 600 is a unit that includes a filament and a Wehnelt electrode. By replacing the filament unit, the electron source 210 may be replaced. The filament unit 600 is detachably supported by a supporting member 700.

The illumination optical system 220 and the imaging optical system 240 are accommodated in an electron optical column 206. The body portion 200 is supported by a vibration isolating table 270. Inside the electron gun chamber 202 and the electron optical column 206, a vacuum state is maintained by the vacuum pumping system 500. The electron gun chamber 202 has a chamber door 204 that is provided for access to the interior of the electron gun chamber 202.

In the body portion 200, the illumination optical system 220 focuses an electron beam emitted from the electron source 210 to form an electron probe and deflects the electron beam. This enables scanning the sample S with the electron probe. In the transmission electron microscope 2, the detector 260 detects the electrons that have passed through the sample S while the sample S is scanned by the electron probe, enabling the acquisition of an STEM image. Furthermore, in the transmission electron microscope 2, the illumination optical system 220 illuminates the sample S with an electron beam in parallel, while the imaging optical system 240 forms a TEM image with the electrons that have passed through the sample S. This enables the imager 250 to capture the TEM image.

Note that the configuration of the body portion 200 is not particularly limited and may include, for example, various detectors, various spectrometers, various manipulators, and the like. For example, the body portion 200 may include an EDS detector that performs measurements using energy-dispersive X-ray spectroscopy (EDS).

The sample S is supported inside the electron optical column 206 by the sample holder 300. The sample holder 300 is inserted into the insertion port of the holder support portion 230. The sample holder 300 is designed to enables its insertion into and extraction from the insertion port of the holder support portion 230. Accordingly, the sample holder 300 is capable of being attached to and detached from the holder support portion 230.

The controller 400 controls each unit of the transmission electron microscope 2. The controller 400 includes, for example, a processor such as a central processing unit (CPU) and storage devices (memories) such as a random access memory (RAM) and a read-only memory (ROM). The storage devices store programs and data for performing various control. The function of the controller 400 is implemented by executing a program on a processor. Note that the controller 400 may be implemented, for example, as a general-purpose circuit such as a microcontroller or a microprocessor that operates according to a program, or as a dedicated circuit such as an application-specific integrated circuit (ASIC).

The vacuum pumping system 500 vacuum-evacuates the electron gun chamber 202, the space inside the electron optical column 206, and the space in which the imager 250 or the detector 260 is arranged, and the like. The vacuum pumping system 500 is controlled by the controller 400. Note that a computer and the vacuum pumping system 500 functioning as the controller 400 may be positioned outside the housing 100.

### 1.2. Housing

FIG. 2 is a perspective view schematically illustrating the housing 100. As illustrated in FIG. 2, the housing 100 has a rectangular prism shape. The housing 100 includes a plurality of plates. The plates are metallic plates. The housing 100 covers the body portion 200 with the plurality of plates. As a result, the body portion 200 is not visually recognizable from the outside of the housing 100. Note that the housing 100 may include a plurality of resinous plates and cover the body portion 200 with the resinous plates.

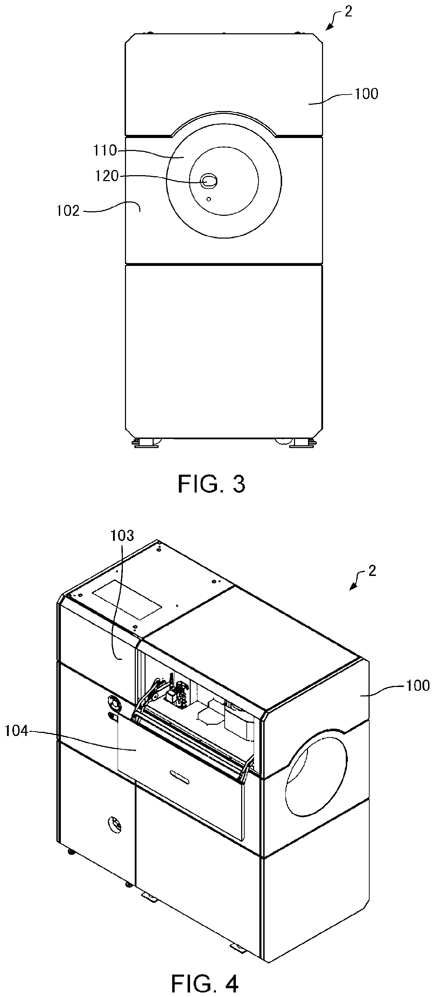

FIG. 3 is a front elevation schematically illustrating the transmission electron microscope 2.

As illustrated in FIGS. 2 and 3, the housing 100 has a recessed portion 110 formed thereon. The recessed portion 110 is provided on a side surface 102 of the housing 100. The side surface 102 is a surface that constitutes the front of the housing 100. At the bottom of the recessed portion 110, a replacement port 120 is formed. The replacement port 120 serves as an opening portion that enables the sample holder 300 to access the insertion port of the holder support portion 230.

FIG. 4 is a perspective view schematically illustrating the housing 100 with the housing door 104 opened. The housing door 104 is provided on a side surface 103 of the housing 100. By opening the housing door 104, access to the chamber door 204 provided on the electron gun chamber 202 is enabled.

### 1.3. Electron Gun Chamber

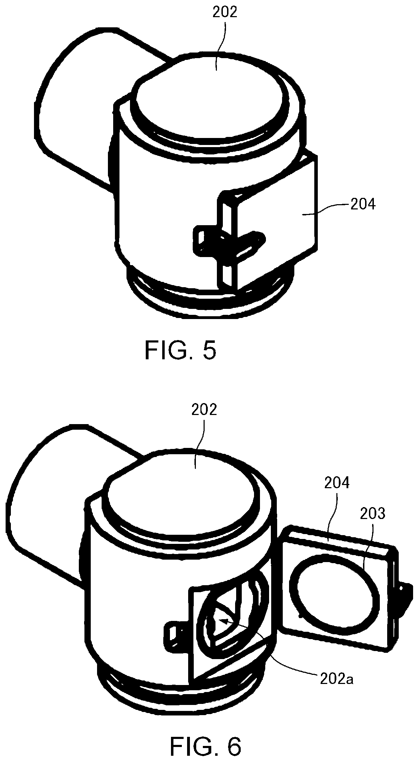

FIGS. 5 and 6 are perspective views schematically illustrating the electron gun chamber 202. Note that FIG. 5 illustrates the state where the chamber door 204 is closed, and FIG. 6 illustrates the state where the chamber door 204 is opened.

As illustrated in FIGS. 5 and 6, the chamber door 204 is provided on the side wall of the electron gun chamber 202. The side wall of the electron gun chamber 202 has a replacement port 202a that penetrates through the side wall, and the chamber door 204 enables the replacement port 202a to be sealed air-tightly. The chamber door 204 has an O-ring 203 that enables the gap between the chamber door 204 and the side wall of the electron gun chamber 202 to be sealed air-tightly.

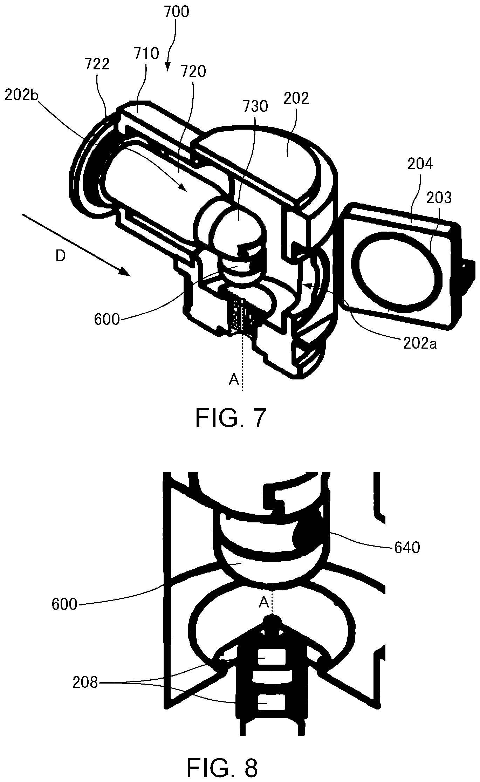

FIG. 7 is a perspective view schematically illustrating the electron gun chamber 202, the supporting member 700, and the filament unit 600.

As illustrated in FIG. 7, the transmission electron microscope 2 includes the filament unit 600 and the supporting member 700 that supports the filament unit 600.

The electron gun chamber 202 includes a cylindrical side wall, a flange that seals the upper part of the side wall, and a base part that seals the bottom of the side wall and has a passage for an electron beam.

The filament unit 600 is supported inside the electron gun chamber 202 by the supporting member 700. The supporting member 700 detachably supports the filament unit 600 inside the electron gun chamber 202. The supporting member 700 is provided on the side wall of the electron gun chamber 202. The supporting member 700 is connected to the side wall of the electron gun chamber 202. The supporting member 700 is inserted into a through-hole 202b formed in the side wall of the electron gun chamber 202.

The supporting member 700 extends from the side wall of the electron gun chamber 202 to the center of the electron gun chamber 202. An extending direction D of the supporting member 700 is perpendicular to an optical axis A of the electron source 210. The extending direction D of the supporting member 700 is a horizontal direction, while the optical axis A of the electron source 210 is a vertical direction. For example, the electron source 210 is positioned on the central axis of the cylindrical electron gun chamber 202. For example, the optical axis A of the electron source 210 is positioned on the central axis of the electron gun chamber 202.

Assuming that the extending direction D of the supporting member 700 is defined as a first direction, the chamber door 204 is positioned in the first direction from the supporting member 700. In other words, when viewed from the supporting member 700, the chamber door 204 is positioned in the extending direction D of the supporting member 700. The replacement port 202a provided with the chamber door 204 and the through-hole 202b into which the supporting member 700 is inserted face each other.

The supporting member 700 includes a pipe 710, an insulator 720, a flange 722, and an attachment part 730. The pipe 710 is inserted into the through-hole 202b. The pipe 710 and the side wall of the electron gun chamber 202 are bonded by welding or the like.

The insulator 720 is accommodated in the pipe 710. The flange 722 is bonded to the end of the pipe 710. The insulator 720 is fixed to the flange 722. The insulator 720 supports a high-voltage cable that supplies power to the electron source 210. The high-voltage cable is connected to a high-voltage power supply. The high-voltage power supply serves as a power supply that generates a negative high voltage to accelerate the electrons emitted from the electron source 210. The insulator 720 insulates the high-voltage cable.

The insulator 720 extends from the side wall of the electron gun chamber 202 to the center of the electron gun chamber 202. The insulator 720 is, for example, cylindrical, and its central axis is parallel to the extending direction D. The insulator 720 has the attachment part 730 provided at its end to attach the filament unit 600.

By the attachment of the filament unit 600 to the attachment part 730, the electron source 210 is arranged at the center of the electron gun chamber 202. As described above, the position of the filament unit 600 is determined by attaching the filament unit 600 to the attachment part 730. In other words, by attaching the filament unit 600 to the attachment part 730, the alignment of the optical axis A of the electron source 210 with the optical axis of the illumination optical system 220 is enabled.

FIG. 8 is a perspective view schematically illustrating the bottom of the electron gun chamber 202.

At a base part positioned at the bottom of the electron gun chamber 202, an alignment coil 208 of a double-deflection system is provided. By the alignment coil 208 of the double-deflection system, the two-dimensional deflection of an electron beam is enabled. The alignment coil 208 of the double-deflection system is used to correct the shift of the optical axis A of the electron source 210 with respect to the optical axis of the illumination optical system 220. As illustrated in FIG. 8, the filament unit 600 has a pin inserting hole 640 provided to fix the filament unit 600 to a jig, which will be described later.

### 1.4. Filament Unit

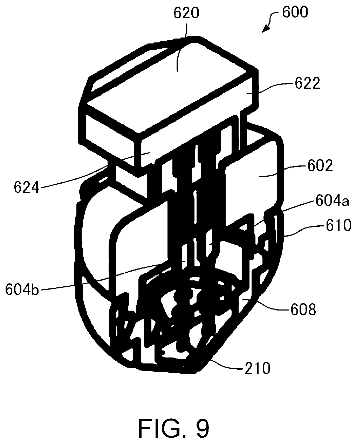

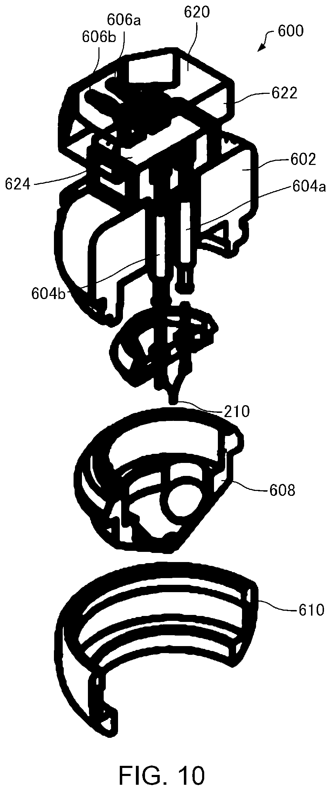

FIG. 9 is a cross-sectional perspective view schematically illustrating the filament unit 600. FIG. 10 is an exploded perspective view schematically illustrating the filament unit 600.

As illustrated in FIGS. 9 and 10, the filament unit 600 includes the electron source 210, a base 602, sockets 604a and 604b, connecting terminals 606a and 606b, a Wehnelt electrode 608, a fixing ring 610, and a rotation preventing member 620 (an example of an engaging part).

The electron source 210 is, for example, a tungsten filament. By heating the tungsten filament through feeding a current, the emission of thermoelectrons from the tungsten filament is enabled. One end of the electron source 210 is connected to a connecting pin, and the connecting pin is inserted into the socket 604a. Similarly, the other end of the electron source 210 is connected to a connecting pin, and the connecting pin is inserted into the socket 604b.

The sockets 604a and 604b and the connecting terminals 606a and 606b are fixed to the base 602. The socket 604a is electrically connected to the connecting terminal 606a. The socket 604b is electrically connected to the connecting terminal 606b. As a result, the one end of the electron source 210 is electrically connected to the connecting terminal 606a, while the other end of the electron source 210 is electrically connected to the connecting terminal 606b.

A bias voltage is applied to the Wehnelt electrode 608. By the bias voltage applied to the Wehnelt electrode 608, the control of the current amount of electrons emitted from the electron source 210 is enabled. The Wehnelt electrode 608 is fixed to the base 602 by the fixing ring 610. The Wehnelt electrode 608 has a plurality of evacuating holes formed therein. This enables efficient evacuation around the electron source 210. The plurality of evacuating holes are symmetrically provided with respect to the optical axis A of the electron source 210.

The rotation preventing member 620 is fixed to the base 602. The rotation preventing member 620 has protruding parts 622 and 624.

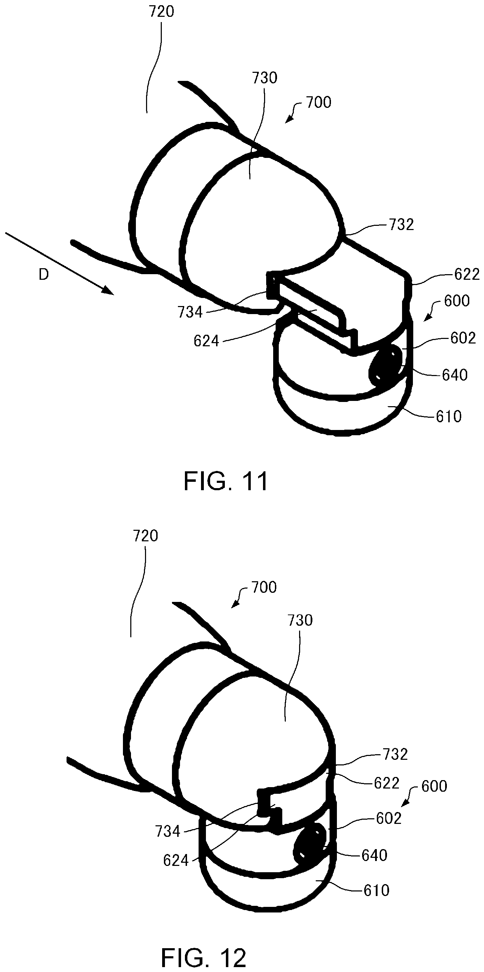

FIG. 11 is a perspective view schematically illustrating the state where the filament unit 600 is being attached to the attachment part 730 of the supporting member 700. FIG. 12 is a perspective view schematically illustrating the state where the filament unit 600 has been attached to the attachment part 730 of the supporting member 700.

The attachment part 730 has guide grooves 732 and 734 that extend in the extending direction D of the supporting member 700. As illustrated in FIG. 11, the protruding parts 622 and 624 are fitted into the guide grooves 732 and 734, respectively, enabling the filament unit 600 to move linearly along the extending direction D without rotating. As described above, the guide grooves 732 and 734 function as guides to direct the filament unit 600 to the center of the electron gun chamber 202, while the protruding parts 622 and 624 function as engaging parts that engage with the guides. As a result, the filament unit 600 is moved linearly along the extending direction D of the supporting member 700, enabling the positioning of the filament unit 600.

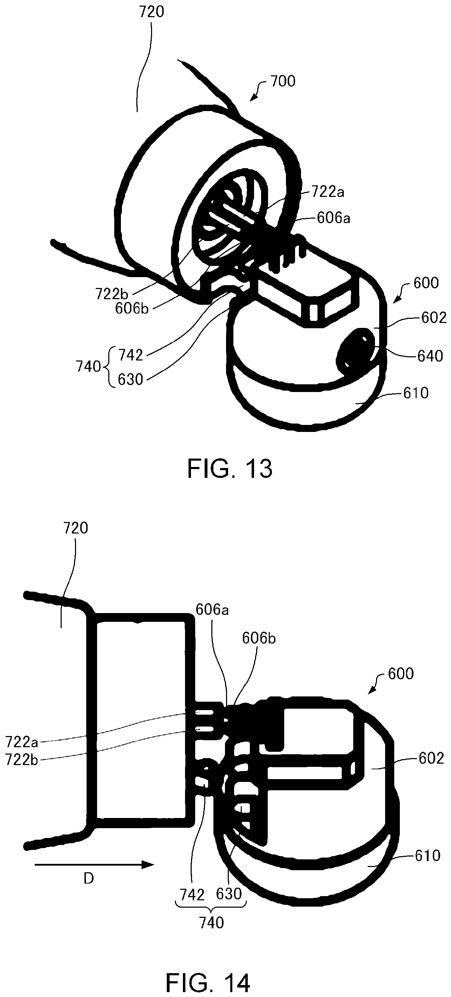

FIG. 13 is a perspective view schematically illustrating the state where the filament unit 600 has been attached to the attachment part 730 of the supporting member 700.

As illustrated in FIG. 13, the supporting member 700 has terminals 722a and 722b. The terminals 722a and 722b are electrically connected to a high-voltage power supply via a high-voltage cable. The terminals 722a and 722b are held by the insulator 720. The terminals 722a and 722b protrude in the extending direction D from the tip of the insulator 720.

By attaching the filament unit 600 to the attachment part 730, the connecting terminal 606a of the filament unit 600 is inserted into the terminal 722a, and the connecting terminal 606b of the filament unit 600 is inserted into the terminal 722b. Thus, the connecting terminal 606a is electrically connected to the terminal 722a, and the connecting terminal 606a is electrically connected to the terminal 722b. For example, the terminals 722a and 722b are sockets, and the connecting terminals 606a and 606b are electrode pins.

The connecting terminal 606a is electrically connected to the terminal 722a, while the connecting terminal 606a is connected to the terminal 722b, enabling the high-voltage power supply to be electrically connected to the electron source 210.

FIG. 14 illustrates a locking mechanism 740 that fixes the filament unit 600 to the supporting member 700.

As illustrated in FIG. 14, the locking mechanism 740 includes a protruding part 742 that protrudes from the tip of the insulator 720 and a clamping portion 630 that clamps the protruding part 742. The clamping portion 630 is provided on the filament unit 600.

By pushing the filament unit 600 into the supporting member 700 from the direction opposite to the extending direction D of the supporting member 700, the protruding part 742 is clamped by the clamping portion 630, thereby fixing the filament unit 600 to the supporting member 700. Furthermore, by applying a force in the extending direction D to the filament unit 600, the protruding part 742 is disengaged from the clamping portion 630. As described above, the clamping portion 630 and the protruding part 742 form the locking mechanism 740 that mechanically fixes the filament unit 600. Furthermore, the clamping portion 630 and the protruding part 742 electrically connect the filament unit 600 and the supporting member 700. Note that the configuration of the locking mechanism 740 is not limited to the example illustrated in FIG. 14.

Note that the above description refers to the case where the filament unit 600 includes the electron source 210 and the Wehnelt electrode 608. However, the configuration of the filament unit 600 is not particularly limited as long as the filament unit 600 includes the electron source 210.

### 2. Replacement Method for Filament Unit

### 2.1. Flow of Replacement Method for Filament Unit

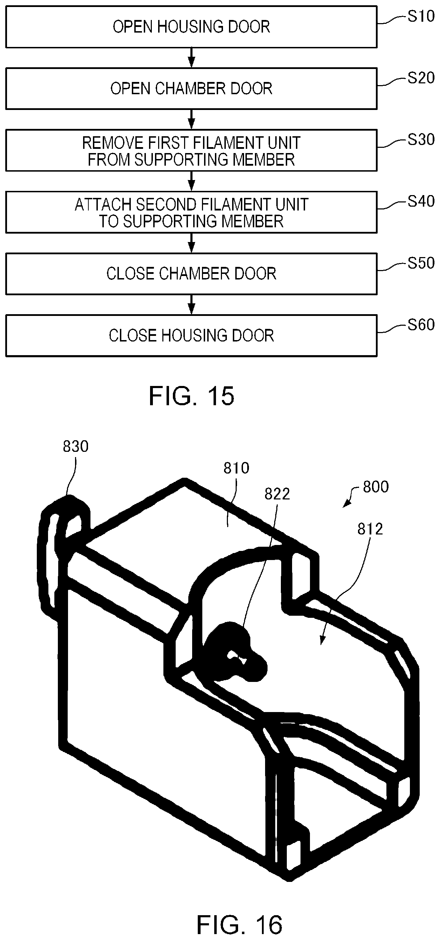

FIG. 15 is a flowchart illustrating an example of a replacement method for the filament unit. As illustrated in FIG. 15, the replacement method for the filament unit includes: a step S10 of opening the housing door 104 of the housing 100; a step S20 of opening the chamber door 204; a step S30 of removing a first filament unit (an example of a first charged particle source unit) from the supporting member 700; a step S40 of introducing a second filament unit (an example of a second charged particle source unit) into the electron gun chamber 202 through the chamber door 204 and attaching the second filament unit to the supporting member 700; a step S50 of closing the chamber door 204; and a step S60 of closing the housing door 104 of the housing 100.

### 2.2. Step S10 of Opening Housing Door

First, as illustrated in FIG. 4, the housing door 104 of the housing 100 is opened. Thus, access to the chamber door 204 is enabled.

### 2.3. Step S20 of Opening Chamber Door

Next, as illustrated in FIG. 6, the chamber door 204 is opened. Thus, access to the interior of the electron gun chamber 202 is enabled. Here, the housing door 104 is provided on the side surface 103 of the housing 100. Furthermore, the chamber door 204 is provided on the side wall of the electron gun chamber 202. As a result, the filament unit 600 may be replaced without the need to perform high-altitude work using a step ladder or the like.

For example, even in a transmission electron microscope that is approximately 1.8 m in height, the chamber door 204 may be positioned at a height of approximately 1.6 m by providing the chamber door 204 on the side wall of the electron gun chamber 202. Thus, even an operator who is approximately 1.5 m tall may replace the filament unit 600 by using a step ladder that is approximately 0.2 m in height. Accordingly, the transmission electron microscope 2 does not require high-altitude work and enables the safe replacement of the filament unit 600.

Note that prior to the step S20 of opening the chamber door 204, the pressure inside the electron gun chamber 202 and the electron optical column 206 is set at atmospheric pressure.

### 2.4. Step S30 of Removing First Filament Unit from Supporting Member

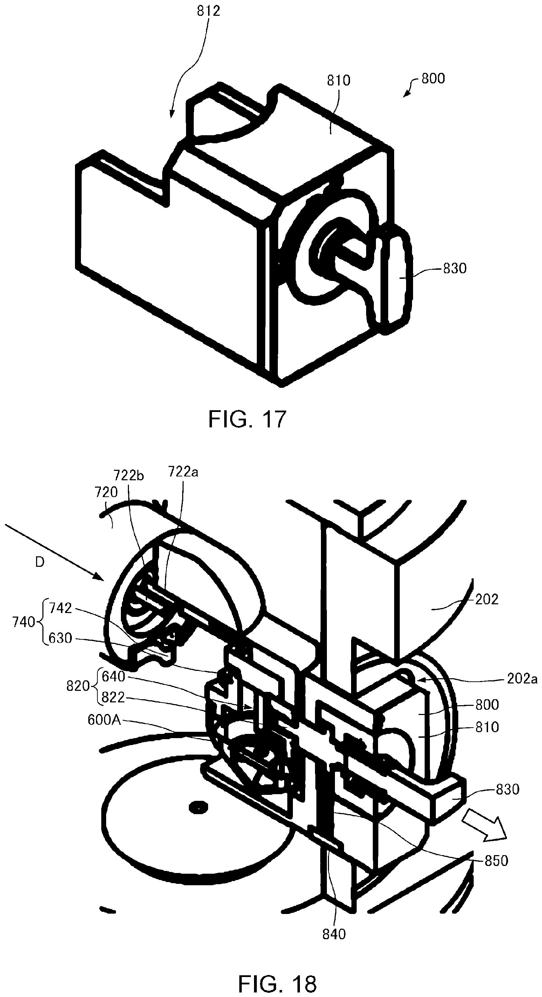

FIGS. 16 and 17 are perspective views schematically illustrating a jig 800. FIG. 18 is a perspective view schematically illustrating the step S30 of removing a first filament unit 600A. Here, the first filament unit 600A refers to a used filament unit 600.

As illustrated in FIG. 18, the jig 800 is used in the step S30 of removing the first filament unit 600A.

As illustrated in FIGS. 16, 17, and 18, the jig 800 includes a unit table 810, a fixing mechanism 820 that fixes the first filament unit 600A, a switching knob 830, a ground electrode 840, and a transmission spring 850.

The unit table 810 has a notch 812 formed therein. The notch 812 is formed in a shape into which the first filament unit 600A is fitted. The first filament unit 600A fitted into the notch 812 is fixed by the fixing mechanism 820.

The fixing mechanism 820 has a pin inserting hole 640 that is provided in the first filament unit 600A and a pin 822 that is inserted into the pin inserting hole 640. A plurality of balls are fixed to the tip of the pin 822. In the pin 822, a shaft that moves inside the pin 822 by the operation of the switching knob 830 is accommodated.

The pin inserting hole 640 has a small-diameter part and a large-diameter part with a diameter larger than that of the small-diameter part. The small-diameter part is formed closer to the entrance side of the pin inserting hole 640 than the large-diameter part.

The switching knob 830 switches between the state where the fixation of the first filament unit 600A is enabled and the state where the fixation is disabled. The rotation of the switching knob 830 allows switching between the state where the fixation is enabled and the state where the fixation is disabled. The switching knob 830 is connected to the pin 822.

When the fixation is enabled by rotating the switching knob 830, the plurality of balls fixed to the tip of the pin 822 are pushed outside the pin 822 by the shaft and caught at the step between the small-diameter part and the large-diameter part of the pin inserting hole 640. Thus, the fixation of the first filament unit 600A to the unit table 810 is enabled.

When the fixation is disabled by rotating the switching knob 830, the plurality of balls move into the pin 822 and the pin 822 passes through the small-diameter part of the pin inserting hole 640. Thus, the cancellation of the fixation of the first filament unit 600A is enabled.

Note that the means by which the fixing mechanism 820 fixes the first filament unit 600A is not particularly limited.

As illustrated in FIG. 18, the ground electrode 840 is electrically connected to the first filament unit 600A, which is fixed to the unit table 810, via the transmission spring 850 and the pin 822. One end of the transmission spring 850 is connected to the ground electrode 840, and the other end thereof is connected to the pin 822. As a result, the electrical connection between the ground electrode 840 and the first filament unit 600A is enabled by the transmission spring 850 and the pin 822. The transmission spring 850 and the pin 822 function as wiring to electrically connect the first filament unit 600A and the ground electrode 840.

In the step S30 of removing the first filament unit 600A from the supporting member 700, the jig 800 is first attached to the first filament unit 600A supported by the supporting member 700. Specifically, the first filament unit 600A is fitted into the notch 812 while its fixation is disabled. Next, switch over to the state where the fixation is enabled by the switching knob 830 is implemented. Thus, the jig 800 is fixed to the first filament unit 600A.

Then, with the jig 800 gripped, a force greater than the force exerted by the locking mechanism 740 to hold the first filament unit 600A is applied in the extending direction D of the supporting member 700 to extract the first filament unit 600A from the supporting member 700. Thus, the removal of the first filament unit 600A from the supporting member 700 is enabled. At this time, the connecting terminal 606a disconnects from the terminal 722a, and the connecting terminal 606b disconnects from the terminal 722b.

The first filament unit 600A with the jig 800 attached is extracted to the outside of the electron gun chamber 202 through the replacement port 202a. Here, as illustrated in FIG. 18, the ground electrode 840 is brought into contact with the electron gun chamber 202 when the jig 800 passes through the replacement port 202a. Thus, the flow of charges accumulated in the first filament unit 600A to ground is enabled. Because the ground electrode 840 is provided at the bottom of the unit table 810, the contact between the ground electrode 840 and the side wall of the electron gun chamber 202 is facilitated.

### 2.5. Step S40 of Attaching Second Filament Unit to Supporting Member

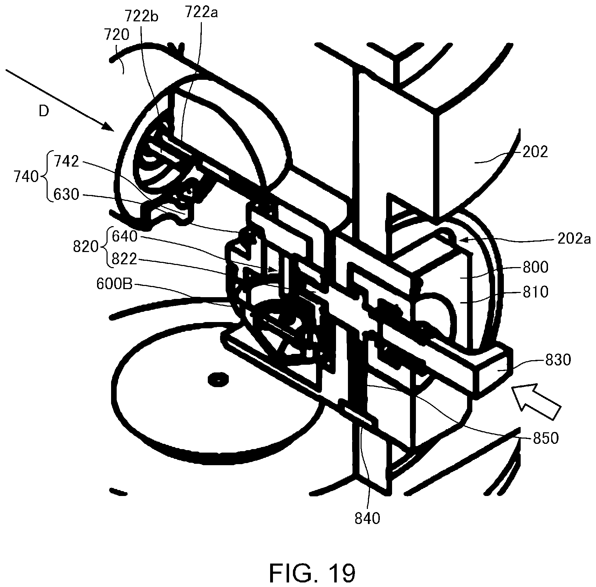

FIG. 19 is a perspective view schematically illustrating the step S30 of attaching a second filament unit 600B. Here, the second filament unit 600B refers to a brand new filament unit 600 prior to use. Note that the second filament unit 600B may also be one obtained by replacing the filament of the first filament unit 600A with a new filament.

In the step S40 of attaching the second filament unit 600B to the supporting member 700, the jig 800 is first attached to the second filament unit 600B. Next, with the jig 800 gripped, the second filament unit 600B with the jig 800 attached is introduced into the electron gun chamber 202 through the replacement port 202a.

Then, as illustrated in FIG. 11, with the protruding parts 622 and 624 fitted into the guide grooves 732 and 734 of the supporting member 700, respectively, the second filament unit 600B is pushed into the supporting member 700 in the direction opposite to the extending direction D. Thus, the second filament unit 600B is guided and moved along the guide grooves 732 and 734 and is arranged at the center of the electron gun chamber 202.

At this time, as illustrated in FIG. 13, the connecting terminals 606a and 606b are inserted into the terminals 722a and 722b, respectively. Thus, the second filament unit 600B is electrically connected to the high-voltage power supply.

Next, the jig 800 is removed from the second filament unit 600B. Through the above steps, the attachment of the second filament unit 600B to the supporting member 700 is enabled.

### 2.6. Step S50 of Closing Chamber Door

Next, as illustrated in FIG. 5, the chamber door 204 is closed.

### 2.7. Step S60 of Closing Housing Door

Then, as illustrated in FIG. 2, the housing door 104 is closed.

Through the above steps, the replacement of the filament unit 600 is enabled.

### 3. Effects

The transmission electron microscope 2 includes: the electron gun chamber 202; the filament unit 600 with the electron source 210; the supporting member 700 that is provided on the side wall of the electron gun chamber 202 and detachably supports the filament unit 600 inside the electron gun chamber 202; and the chamber door 204 that is provided on the side wall of the electron gun chamber 202 for access to the interior of the electron gun chamber 202. As described above, in the transmission electron microscope 2, it is possible to extract or introduce the filament unit 600 through the chamber door 204 provided on the side wall of the electron gun chamber 202. Therefore, compared to replacing the filament unit 600 by lifting up the electron gun chamber 202, it is easier to replace the filament unit 600.

For example, when replacing the filament unit 600 by lifting up the electron gun chamber 202, an operator has to access the top of the transmission electron microscope and perform high-altitude work. On the other hand, in the transmission electron microscope 2, the chamber door 204 is provided on the side wall of the electron gun chamber 202. Therefore, an operator is able to replace the filament unit 600 safely without the need to perform high-altitude work using a step ladder or the like.

In the transmission electron microscope 2, the supporting member 700 extends from the side wall of the electron gun chamber 202 toward the center of the electron gun chamber 202, and the filament unit 600 is pushed into the supporting member 700 from the direction opposite to the extending direction D of the supporting member 700. As described above, in the transmission electron microscope 2, the direction in which the filament unit 600 is pushed into the supporting member 700 is along the extending direction D of the supporting member 700. Therefore, it is possible to prevent excessive force from being applied to the bonding part between the supporting member 700 and the electron gun chamber 202 when pushing the filament unit 600. As a result, the likelihood of the supporting member 700 being damaged may be reduced. For example, if the direction in which the supporting member 700 extends is perpendicular to the direction in which the filament unit 600 is pushed, excessive force may be applied to the bonding part between the supporting member 700 and the electron gun chamber 202, resulting in the likelihood of the supporting member 700 being damaged.

In the transmission electron microscope 2, the supporting member 700 has the guide grooves 732 and 734 that extend in the extending direction D, and the filament unit 600 has the protruding parts 622 and 624 that engage with the guide grooves 732 and 734, respectively. As a result, when attaching the filament unit 600 to the supporting member 700, it is possible to push the filament unit 600 in the direction along the extending direction D of the supporting member 700. Accordingly, the likelihood of the supporting member 700 being damaged may be reduced.

In the transmission electron microscope 2, the supporting member 700 extends in the first direction from the side wall of the electron gun chamber 202, and the chamber door 204 is positioned in the first direction from the supporting member 700. As a result, in the transmission electron microscope 2, it is possible to easily attach the filament unit 600 to the supporting member 700.

In the transmission electron microscope 2, the supporting member 700 includes the insulator 720, and the insulator 720 holds the first terminals (terminals 722a and 722b) electrically connected to the high-voltage power supply. Furthermore, the filament unit 600 has the second terminals (connecting terminals 606a and 606b) electrically connected to the electron source 210. Furthermore, when the filament unit 600 is attached to the supporting member 700, the first terminal and the second terminal are electrically connected. In other words, when the filament unit 600 is attached to the supporting member 700, the terminals 722a and 722b are electrically connected to the connecting terminals 606a and 606b, respectively. As a result, in the transmission electron microscope 2, the attachment of the filament unit 600 to the supporting member 700 enables the electrical connection between the electron source 210 and the high-voltage power supply.

The transmission electron microscope 2 includes: the illumination optical system 220 that illuminates the sample S with an electron beam; and the imaging optical system 240 that forms an image with the electrons that have passed through the sample S. As a result, in the transmission electron microscope 2, the electron optical column 206 becomes tall. However, because the chamber door 204 is provided on the side wall of the electron gun chamber 202, an operator is able to replace the filament unit 600 safely without the need to perform high-altitude work using a step ladder or the like.

The transmission electron microscope 2 includes the housing 100 that accommodates the electron gun chamber 202 and the electron optical column 206, and the housing door 104 is provided on the side surface 103 of the housing 100 for access to the chamber door 204. As described above, in the transmission electron microscope 2, the housing door 104 is provided on the side surface 103 of the housing 100. Therefore, an operator is able to easily access the chamber door 204 provided on the side wall of the electron gun chamber 202.

The replacement method for the filament unit 600 in the transmission electron microscope 2 includes: the step of opening the chamber door 204; the step of removing the first filament unit 600A from the supporting member 700; and the step of introducing the second filament unit 600B into the electron gun chamber 202 through the chamber door 204 and attaching the second filament unit 600B to the supporting member 700. As described above, in the replacement method for the filament unit 600, it is possible to remove the first filament unit 600A or introduce the second filament unit 600B through the chamber door 204. Therefore, an operator is able to easily replace the filament unit 600.

Furthermore, because the chamber door 204 is provided on the side wall of the electron gun chamber 202, an operator is able to replace the filament unit 600 safely without the need to perform high-altitude work when replacing the filament unit 600 as described above.

In the replacement method for the filament unit 600 in the transmission electron microscope 2, the jig 800 is attached to the first filament unit 600A supported by the supporting member 700, and then the first filament unit 600A is removed from the supporting member 700 with the jig 800 gripped in the step of removing the first filament unit 600A. As a result, an operator is able to remove the first filament unit 600A without touching the first filament unit 600A.

For example, the first filament unit 600A is at a high temperature immediately after use, and an operator may get burned if they directly touch the first filament unit 600A. As a result, in order to remove the first filament unit 600A from the supporting member 700, the operator needs to wait until the first filament unit 600A is sufficiently cooled. On the other hand, in the above replacement method for the filament unit 600, an operator is able to remove the first filament unit 600A from the supporting member 700 without touching the first filament unit 600A. Therefore, the operator is able to remove the first filament unit 600A safely even immediately after use.

In the replacement method for the filament unit 600 in the transmission electron microscope 2, the jig 800 includes the ground electrode 840 and the transmission spring 850 that functions as wiring to electrically connect the first filament unit 600A and the ground electrode 840 attached to the jig 800. Furthermore, in the step of removing the first filament unit 600A, the first filament unit 600A and the ground electrode 840 are electrically connected, and the ground electrode 840 is brought into contact with the electron gun chamber 202. As a result, in the replacement method for the filament unit 600, the flow of charges accumulated in the first filament unit 600A to ground is enabled, reducing the likelihood of an operator being electrically shocked.

In the replacement method for the filament unit 600 in the transmission electron microscope 2, the supporting member 700 extends from the side wall of the electron gun chamber 202 toward the center of the electron gun chamber 202. Furthermore, in the step of attaching the second filament unit 600B to the supporting member 700, the second filament unit 600B is pushed into the supporting member 700 in the direction opposite to the extending direction D. Accordingly, the likelihood of the supporting member 700 being damaged may be reduced.

The replacement method for the filament unit 600 in the transmission electron microscope 2 includes the step of opening the housing door 104 prior to the step of opening the chamber door 204. Because the housing door 104 is provided on the side surface 103 of the housing 100, an operator is able to easily access the chamber door 204 provided on the side wall of the electron gun chamber 202.

### 4. Process Performed by Control Unit

### 4.1. Boosting of Accelerating Voltage

In the transmission electron microscope 2, a boosting process for applying an accelerating voltage (hereinafter also referred to as a "high voltage") may be automatically performed after replacing the filament unit 600. For example, the boosting process may be performed immediately after replacing the filament unit 600 and starting the evacuation inside the electron gun chamber 202 and the electron optical column 206.

The controller 400 performs a conditioning process as part of the boosting process. The conditioning process involves boosting the voltage to a conditioning voltage value, which is an accelerating voltage value higher than the accelerating voltage to be used, and maintaining the boosted voltage for a specified time. In the boosting process, the voltage is reduced from the conditioning voltage value to the target accelerating voltage value after the conditioning process. By performing the conditioning process, the risk of a discharge during use may be reduced.

### 4.2. Boosting Process

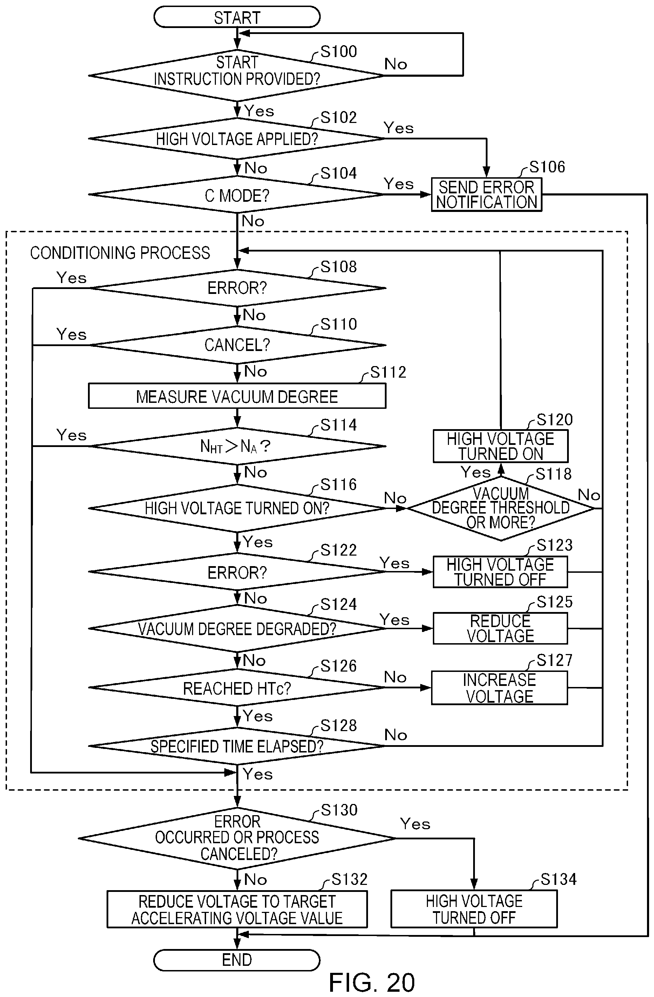

FIG. 20 is a flowchart illustrating an example of the boosting process performed by the controller 400.

First, the controller 400 determines whether the user has provided an instruction to start automatic boosting (step S100). When the user presses a start button for the automatic boosting on a graphical user interface (GUI), the controller 400 determines that the user has provided the instruction to start the automatic boosting.

When it is determined that the user has provided the instruction to start the automatic boosting (Yes in S100), the controller 400 determines whether a high voltage is being applied (S102). This is intended to start the boosting process under the same condition at all times, i.e., in a state where a high voltage is never applied. By performing the boosting process under the uniform condition, the tendency of the device is understandable from the data acquired from the boosting process.

When it is determined that a high voltage is being applied (Yes in step S102), the controller 400 notifies the operator of an error (step S106) and ends the boosting process.

When it is determined that a high voltage is not being applied (No in step S102), the controller 400 determines whether the device is in a conditioning mode (C mode) where a high voltage allows for a conditioning voltage value HTc (step S104). The conditioning voltage value HTc is an accelerating voltage higher than the target accelerating voltage value. By stepping down the conditioning voltage value HTc to the target accelerating voltage value after applying the conditioning voltage value HTc, the risk of a discharge during use at the target accelerating voltage value may be reduced. During ordinary use, the device is not in the conditioning mode. Therefore, when the device is in the conditioning mode, the controller 400 determines that the device is abnormal.

When it is determined that the device is in the conditioning mode (Yes in step S104), the controller 400 notifies the user of an error (step S106) and ends the boosting process.

When it is determined that the device is not in the conditioning mode (No in step S104), the controller 400 starts the conditioning process.

Specifically, the controller 400 determines whether there is an error in the device (step S108). When it is determined that the device has no error (No in step S108), the controller 400 determines whether the user has provided an instruction to cancel the automatic boosting process (step S110).

When it is determined that the user has not provided the instruction to cancel the automatic boosting process (No in step S110), the controller 400 measures the vacuum degree inside the electron gun chamber 202 (step S112). The controller 400 acquires the measurement value of the vacuum degree inside the electron gun chamber 202 from a vacuum gauge that measures the vacuum degree inside the electron gun chamber 202.

The controller 400 stores the measurement value acquired from the vacuum gauge in a storage unit. Furthermore, when information on an attained vacuum degree has not been stored in the storage unit, the controller 400 stores the measurement value in the storage unit as the attained vacuum degree. When the attained vacuum degree has been stored in the storage unit, the controller 400 compares the measurement value with the attained vacuum degree stored in the storage unit, and then updates the attained vacuum degree if the measurement value is higher than the attained vacuum degree.

Next, the controller 400 determines whether the number of times N_{HT} the high voltage was turned on exceeds a preset number N_{A} (step S114). The number of times N_{HT} the high voltage was turned on corresponds to the number of times the high voltage was turned off. When the number of times the high voltage was turned off exceeds the preset number N_{A}, it is highly likely that there is an error in the high-voltage power supply and the like.

When it is determined that the number of times N_{HT} the high voltage was turned on does not exceed the preset number N_{A} (No in step S114), the controller 400 determines whether the high voltage is turned on (step S116).

When it is determined that the high voltage is not turned on (No in step S116), the controller 400 determines whether the vacuum degree inside the electron gun chamber 202 is a threshold or more (step S118). When the measurement value stored in the storage unit is the threshold or more (Yes in step S118), the controller 400 turns on the high voltage (step S120). After turning on the high-voltage power supply, the controller 400 returns to the process in step S108.

On the other hand, when it is determined that the measurement value stored in the storage unit is not the threshold or more (No in step S118), the controller 400 waits for a certain time to increase the vacuum degree and then returns to the process in step S108.

When it is determined that the high voltage is turned on (Yes in step S116), the controller 400 determines whether there is an error in the high-voltage power supply (step S122). When it is determined that the high-voltage power supply has an error (Yes in step S122), the controller 400 turns off the high voltage (step S123). The controller 400 turns off the high-voltage power supply to stop applying the high voltage. Then, the controller 400 returns to step S108.

When it is determined that there is no error in the high-voltage power supply (No in step S122), the controller 400 determines whether the vacuum degree inside the electron gun chamber 202 has been degraded (step S124). The controller 400 acquires the measurement value of the vacuum degree inside the electron gun chamber 202 from the vacuum gauge. The controller 400 compares the measurement value with the attained vacuum degree stored in the storage unit and determines that the vacuum degree has been degraded when the measurement value is lower than the attained vacuum degree and the difference between the measurement value and the attained vacuum degree is a specified value or more. The controller 400 determines that the vacuum degree has not been degraded when the measurement value and the attained vacuum degree do not satisfy the specified relationship.

When it is determined that the vacuum degree has been degraded (Yes in step S124), the controller 400 reduces the high voltage by a predetermined value (step S125). Then, the controller 400 returns to the process in step S108.

When it is determined that the vacuum degree has not been degraded (No in step S124), the controller 400 determines whether the high voltage has reached the conditioning voltage value HTc (step S126). When it is determined that the high voltage has not reached the conditioning voltage value HTc (No in step S126), the controller 400 increases the high voltage by a predetermined value (step S127). Then, the controller 400 returns to the process in step S108.

When it is determined that the high voltage has reached the conditioning voltage value HTc (Yes in step S126), the controller 400 determines whether a specified time has elapsed since the high voltage reached the conditioning voltage value HTc (step S128). The specified time is, for example, 10 minutes. Note that the specified time may be set to any value.

When it is determined that the specified time has not elapsed since the high voltage reached the conditioning voltage value HTc (No in step S128), the controller 400 returns to the process in step S108.

The controller 400 ends the conditioning process when it is determined that the specified time has elapsed since the high voltage reached the conditioning voltage value HTc (Yes in step S128), when it is determined that there is an error in the device (Yes in step S108), when it is determined that the user has provided the instruction to cancel the automatic boosting process (Yes in step S110), or when it is determined that the number of times N_{HT} the high voltage was turned on has exceeded the preset number N_{A} (Yes in step S114).

After ending the conditioning process, the controller 400 determines whether there is an error in the device or whether the process has been canceled (step S130). The controller 400 determines that the device has an error or the process has been canceled (No in step S130) when it is determined that the device has an error (Yes in step S108), when the user has provided the instruction to cancel the automatic boosting process (Yes in step S110), or when the number of times N_{HT} the high voltage was turned on has exceeded the preset number N_{A} (Yes in step S114), and turns off the high voltage (step S134) to end the boosting process.

When it is determined that the specified time has elapsed since the high voltage reached the conditioning voltage value HTc (Yes in step S128), the controller 400 determines that there is no error in the device or the process has not been canceled (No in step S130), and then reduces the voltage to the target accelerating voltage value (step S132). Thus, the accelerating voltage may be set to the target accelerating voltage value. After reducing the voltage to the target accelerating voltage value, the controller 400 ends the boosting process.

### 4.3. Start Function

In cases where the accelerating voltage to be used is not the maximum accelerating voltage, or where the time during which the interior of the electron gun chamber 202 or the electron optical column 206 is exposed to the atmosphere is short during the replacement of the filament unit 600, the risk of a discharge is low. In such cases, a start function may be used without performing the conditioning process described above. The start function optimizes the accelerating voltage, the filament, and the state of an optical system according to conditions set by the user and enables immediate observation.

The boosting with the start function is designed for user's ordinary use and is not suitable when the electron gun chamber 202 or the filament unit 600 undergoes degassing or when there are extraneous matters such as dust. If there is a risk of a discharge, the conditioning function described above is used. In the transmission electron microscope 2, the two automatic boosting methods are provided according to the states of the device, enabling the user to be free from the device while minimizing the downtime of the device.

### 4.4. Start Process

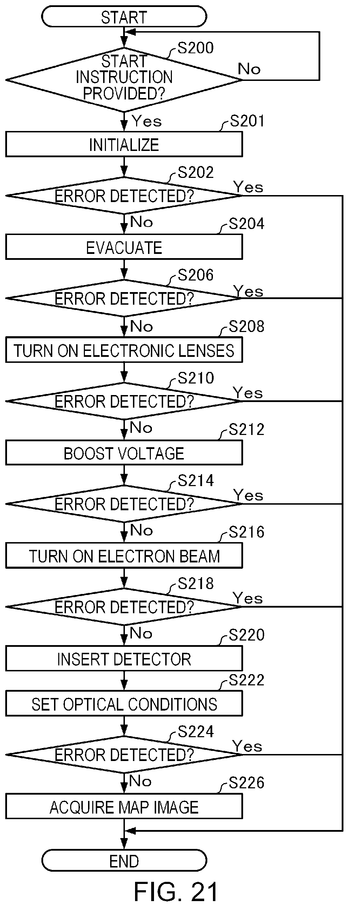

FIG. 21 is a flowchart illustrating an example of a start process performed by the controller 400.

First, the controller 400 determines whether the user has provided an instruction to start the start process (step S200). When the user presses a start button for the start process on the GUI, the controller 400 determines that the user has provided the instruction to start the start process.

Note that before starting the start process, the user selects the target accelerating voltage value and observation conditions on the GUI screen. For example, the user may select the accelerating voltage value or the observation conditions from a pull-down menu on the GUI screen.

When it is determined that the user has provided the instruction to start the start process (Yes in step S200), the controller 400 initializes the settings of specific items (step S201). For example, in a case where beam blanking is turned on, the beam blanking is initialized to be turned off. Furthermore, the controller 400 enables "Bright" when the image field is not set to "Bright." In a case where "IOS off" is turned on, "IOS off" is set to be turned off. Furthermore, the controller 400 sets all Wobblers to be turned off.

By initializing these items, observation may be always started under the same conditions even if the previous user ended the operation with different settings.

Next, the controller 400 confirms whether there is an error in the device (step S202). When it is determined that there is an error in the device and the error may not be resolved by resetting the device, the controller 400 determines that the device has the error (Yes in step S202) and ends the start process. When it is determined that the error in the device may be resolved by resetting the device, the controller 400 resets the device and confirms again whether there is an error in the device.

When it is determined that there is no error in the device (No in step S202), the controller 400 determines whether the vacuum degree inside the electron gun chamber 202 and the electron optical column 206 has reached a level at which boosting may start without any issues (step S204). When the vacuum degree has not reached the level at which boosting may start without any issues, the controller 400 waits for a specified time and then determines again whether the vacuum degree has reached the level at which boosting may start without any issues. When the vacuum degree has not reached the required level even after waiting for the specified time, the controller 400 determines that there is an error in the device (Yes in step S206) and ends the start process.

When it is determined that the vacuum degree has reached the level at which boosting my start without any issues and there is no error in the vacuum degree (No in step S206), the controller 400 starts energizing a plurality of electronic lenses that constitute the illumination optical system 220 and the imaging optical system 240 (S208). Thus, the illumination optical system 220 and the imaging optical system 240 become available.

Here, a current needs to be supplied to the electronic lenses in order to use the transmission electron microscope 2. However, when the transmission electron microscope 2 is not in use, it is preferable to stop the current supplied to the electronic lenses. This is because maintaining the current supplied to the electronic lenses consumes a large amount of power and creates a high environmental burden. Accordingly, the transmission electron microscope 2 stops the current supplied to the electronic lenses when it is not in use, and starts the energization of the electronic lenses in the process of S208. When the specified current is not being supplied to the electronic lenses, the controller 400 determines that there is an error in the device (Yes in step S210) and ends the start process.

When it is determined that the specified current is being supplied to the electronic lenses and there is no error in the electronic lenses (No in step S210), the controller 400 boosts the accelerating voltage to the target accelerating voltage value (step S212).

Here, the target accelerating voltage value is set using the pull-down menu on the GUI screen. The controller 400 boosts the accelerating voltage such that it becomes equal to the target accelerating voltage value. The boosting with the start function is equipped with a mechanism to adjust and boost the accelerating voltage to prevent a discharge. This mechanism will be described in "4.5. Boosting Process S212," which will be described later.

When the accelerating voltage has not been boosted to the target accelerating voltage value, the controller 400 determines that there is an error in the high voltage system (Yes in step S214) and ends the start process.

When it is determined that there is no error in the high-voltage system because the accelerating voltage has been boosted to the target accelerating voltage value (No in step S214), the controller 400 causes the electron source 210 to generate an electron beam (step S216).

First, the controller 400 determines whether the sample holder 300 has been inserted into the holder support portion 230. When the sample holder 300 has not been inserted, the controller 400 determines that examination will not be performed immediately and skips the processes in steps S216 and S218. In this case, the filament will not be energized.

When it is determined that the sample holder 300 has been inserted, the controller 400 starts energizing the electron source 210, that is, the filament. At this time, if a current is not supplied to the filament despite its energization, the controller 400 determines that the filament is broken (Yes in step S218) and ends the start process.

When it is determined that a current is supplied to the filament, the controller 400 applies a high voltage to start emitting an electron beam. The controller 400 determines whether the target emission current has been reached. When the target emission current has not been reached even after the elapse of a specified time, the controller 400 determines that there is an error in the device (Yes in step S218) and ends the start process.

When it is determined that the electron beam of the target emission current has been emitted (No in step S218), the controller 400 inserts a detector corresponding to a use mode (S220).

The controller 400 inserts a detector corresponding to a use mode previously set on the GUI screen by the user. First, the controller 400 determines whether the sample holder 300 has been inserted into the holder support portion 230. When the sample holder 300 has not been inserted, the controller 400 determines that examination will not be performed immediately and skips the process in step S220. In this case, the detector will not be inserted.

When it is determined that the sample holder 300 has been inserted, the controller 400 inserts a detector corresponding to a set use mode. For example, when a TEM mode has been set although not illustrated, a scan detector is moved outside the optical axis, and a fluorescent screen is inserted into the optical axis. Furthermore, for example, when a mode for performing measurements using EDS has been set although not illustrated, an EDS detector is inserted.

Next, the controller 400 sets optical conditions (step S222).

The controller 400 controls the illumination optical system 220 and the imaging optical system 240 to meet the set optical conditions. When the TEM mode is used as the imaging mode, the function of maintaining constant brightness on the sample surface regardless of magnification (brightness magnification link function) is initialized. Thus, the user may start using the device under the same conditions, regardless of the conditions under which the device ended last time.

First, the controller 400 determines whether the sample holder 300 has been inserted into the holder support portion 230. When the sample holder 300 has not been inserted, the controller 400 determines that examination will not be performed immediately and skips the process in step S222. When it is determined that the sample holder 300 has been inserted, the controller 400 changes to the imaging mode corresponding to the set optical conditions. Next, the controller 400 initializes the brightness magnification link function. Note that the initialization of the brightness magnification link function will be described later. Then, the controller 400 sets the deflector system to the default value and changes the observation magnification to the set observation magnification. Through the above processes, the optical conditions may be set.

In the initialization of the brightness magnification link function, the mode is first changed to the Mag mode, and the magnification is set to the lowest level. Next, the spot size is changed, and the excitation value of the condenser lens is initialized. Then, the objective lens aperture is inserted into the optical axis, and the focus value of the objective lens is set to its default value. Finally, the LOW Mag mode is initialized similarly. Through the above processes, the brightness magnification link function may be initialized.

Next, the controller 400 confirms whether there is an error in the device (step S224). When it is determined that there is an error in the device and the error may not be resolved by resetting the device, the controller 400 determines that the device has the error (Yes in step S224) and ends the start process. When it is determined that the error in the device may be resolved by resetting the device, the controller 400 resets the device and confirms again whether there is an error in the device.

When it is determined that there is no error in the device (No in step S224), the controller 400 acquires a map image (S226). The map image is an image obtained by photographing the entire field of view of the sample S. The controller 400 displays the photographed map image on the GUI screen. This map image displays the position being observed by the user and enables understanding of which region is being observed. Furthermore, the point to be observed may also be determined from the map image.

First, the controller 400 determines whether the sample holder 300 has been inserted into the holder support portion 230. When the sample holder 300 has not been inserted, the controller 400 determines that examination will not be performed immediately and skips the process in step S226.

The controller 400 determines whether a map image has already been acquired. When a map image has been acquired, the controller 400 skips the process in S226. Next, the controller 400 opens the beam shutter and sets the magnification to the lowest level. Then, the controller 400 changes the spot size (the size of the electron beam). Next, the controller 400 changes the excitation value of the condenser lens to adjust the brightness. Then, the controller 400 moves all the apertures outside the optical axis. Next, the controller 400 adjusts the position of the sample S and photographs a map image with the imager 250. After photographing the map image, the controller 400 restores the conditions for the optical system to the conditions before the process in S226. Finally, the controller 400 closes the beam shutter. Through the above processes, the map image may be acquired. After acquiring the map image, the controller 400 ends the start process.

### 4.5. Boosting Process S212

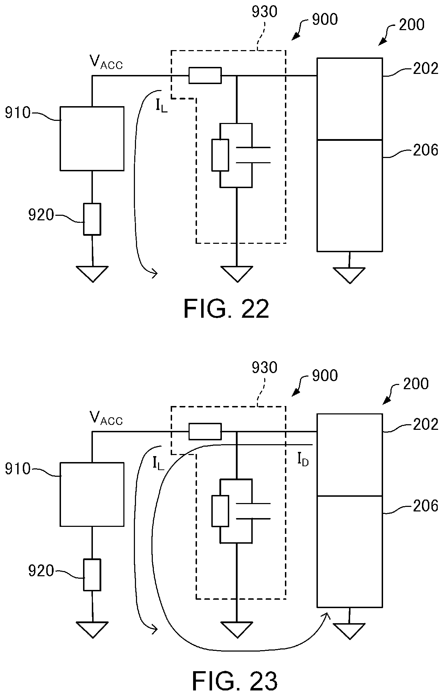

FIG. 22 is a diagram illustrating a power supply circuit 900 that applies an accelerating voltage V_{ACC}. As illustrated in FIG. 22, the power supply circuit 900 includes a high-voltage generating circuit (high-voltage power supply) 910, a load-current detecting circuit 920, and a filter circuit 930.

A slight load current I_{L} needs to be supplied to generate a high voltage. The load current I_{L} flows through the filter circuit 930, which removes high-frequency noise, as well as the high-voltage generating circuit 910, and the load-current detecting circuit 920 monitors the current value of the load current I_{L}.

FIG. 23 is a diagram illustrating the power supply circuit 900 in a case where a discharge occurs. When a discharge occurs during boosting, the discharge current I_{D} from the electron gun portion overlaps with the load current I_{L} and flows into the load-current detecting circuit 920. The load current I_{L} has a theoretical value according to the accelerating voltage value. Therefore, by comparing the current value of the load current I_{L} after being boosted by a constant value with the theoretical value, it is possible to detect an increase in the current value due to a slight discharge. Thus, boosting may be performed while avoiding discharge.

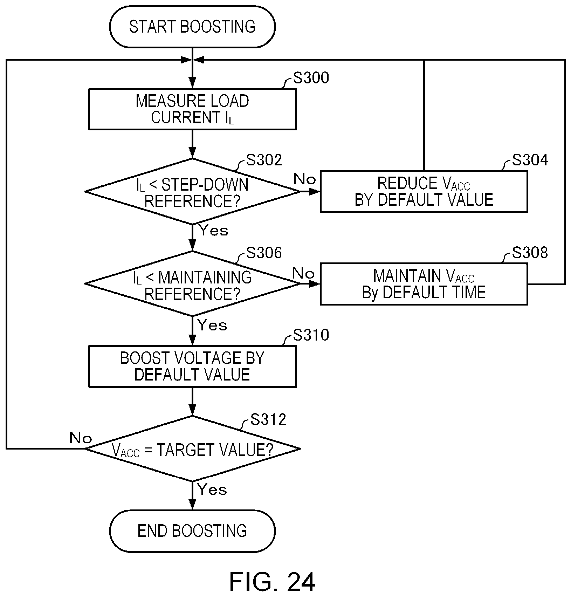

FIG. 24 is a flowchart illustrating an example of the boosting process in S212 performed by the controller 400.

When starting the boosting process S212, the controller 400 first acquires the measurement value of the load current I_{L} measured by the load-current detecting circuit 920 (S300). The controller 400 determines whether the measurement value of the load current I_{L} is smaller than the step-down reference (S302).

When the measurement value of the load current I_{L} is the step-down reference or more, that is, when I_{L} < the step-down reference is not satisfied (No in step S302), the controller 400 determines that a discharge has occurred and reduces the accelerating voltage V_{ACC} by the default value (S304). After reducing the accelerating voltage V_{ACC} by the default value (after step S304), the controller 400 returns to step S300.

When the measurement value of the load current I_{L} is smaller than the step-down reference, that is, when I_{L} < the step-down reference is satisfied (Yes in step S302), the controller 400 determines whether the measurement value is smaller than the maintaining reference (S306).

When the measurement value of the load current I_{L} is the maintaining reference or more, that is, when I_{L} < the maintaining reference is not satisfied (No in step S306), the controller 400 determines that a discharge has occurred and maintains the accelerating voltage V_{ACC} for the default time (S308). After maintaining the accelerating voltage V_{ACC} for the default time (after step S308), the controller 400 returns to step S300.

When the measurement value of the load current I_{L} is smaller than the maintaining reference, that is, when I_{L} < the maintaining reference is satisfied (Yes in step S306), the controller 400 boosts the accelerating voltage V_{ACC} by the default value (step S310). As described above, when the measurement value of the load current I_{L} is smaller than the step-down reference and is smaller than the maintaining reference, the controller 400 boosts the accelerating voltage V_{ACC} by the default value. Note that the value of the maintaining reference is smaller than the value of the step-down reference. The value of the step-down reference and the value of the maintaining reference may be set at any value.

Next, the controller 400 determines whether the accelerating voltage V_{ACC} has become equal to the target accelerating voltage value (step S312). When it is determined that the accelerating voltage V_{ACC} has not become equal to the target accelerating voltage value (No in step S312), the controller 400 returns to step S300. The controller 400 repeatedly performs the processes in steps S300, S302, S304, S306, S308, S310, and S312 until the accelerating voltage V_{ACC} becomes equal to the target accelerating voltage value.

When it is determined that the accelerating voltage V_{ACC} has become equal to the target accelerating voltage value (Yes in step S312), the controller 400 ends the boosting process S212.

Note that the controller 400 may confirm whether there is an error in the device before the process in step S300 where the load current I_{L} is measured. When it is determined that there is an error in the device (Yes in step S214), the controller 400 ends the start process. Furthermore, when unable to end the boosting process S212 within the specified number of repetitions, the controller 400 may determine that there is an error in the device (Yes in step S214) and end the start process. Furthermore, when unable to end the boosting process S212 within a specified time, the controller 400 may determine that there is an error in the device (Yes in step S214) and end the start process.

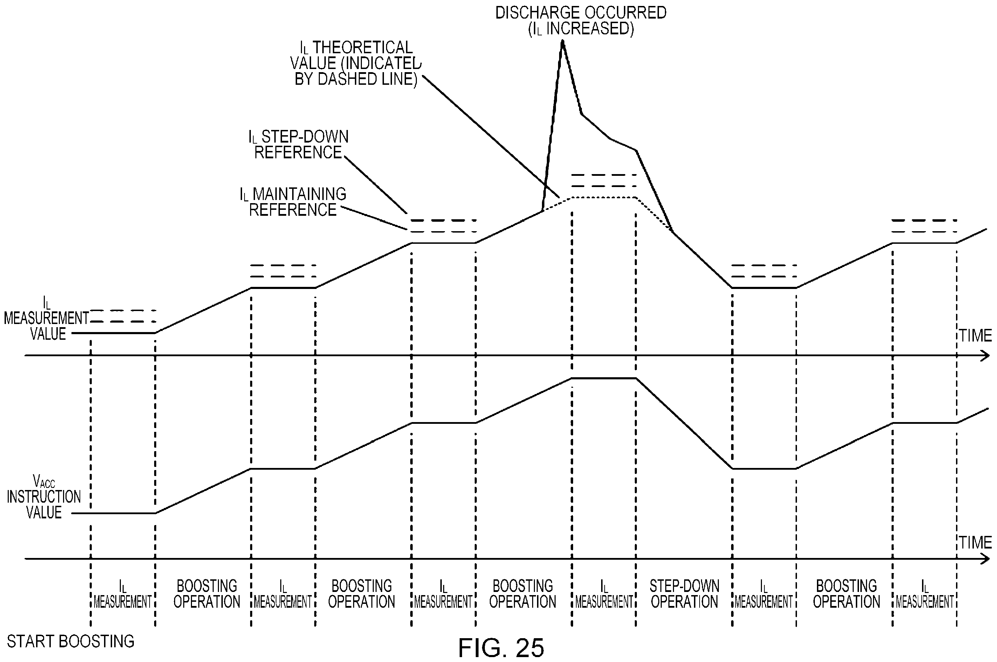

FIG. 25 is a diagram illustrating an example of a boosting and step-down operation for an accelerating voltage. When the measurement value of the load current I_{L} falls within the reference, that is, when the measurement value of the load current I_{L} is smaller than the maintaining reference, the measurement of the load current I_{L} and the boosting of the accelerating voltage by the default value are repeatedly performed. The load current I_{L} deviates from the theoretical value when it unexpectedly increases due to a discharge. Because the measurement value of the load current I_{L} exceeds the step-down reference in the example in FIG. 25, the controller 400 performs the step-down operation of the accelerating volage V_{ACC}. After performing the step-down operation of the accelerating voltage V_{ACC}, the controller 400 measures the load current I_{L} again. When the measurement value of the load current I_{L} is smaller than the maintaining reference, the controller 400 resumes the boosting of the accelerating voltage V_{ACC}.

### 4.6. Effects

In the transmission electron microscope 2, the interior of the electron gun chamber 202 and the electron optical column 206 is exposed to the atmosphere during the replacement of the filament unit 600. Therefore, a discharge is likely to occur when an accelerating volage is applied. Conventionally, in order to safely boost an accelerating voltage, an operator needs to carefully apply a high voltage and perform aging after the vacuum degree inside the electron optical column 206 becomes sufficiently high. Here, the aging refers to a process in which an accelerating voltage larger than the accelerating voltage to be used is applied to reduce the risk of a discharge associated with the accelerating voltage to be used.

As illustrated in FIG. 20, the transmission electron microscope 2 may perform aging automatically, enabling an accelerating voltage to be easily boosted without requiring an operator to be in front of the device. Furthermore, when aging is not required, the transmission electron microscope 2 enables the accelerating voltage to be boosted using the start function.

### 5. Modified Examples

Note that the invention is not limited to the embodiments described above and may be modified and implemented in various ways within the scope of the invention.

For example, the embodiments described above illustrates the case where the transmission electron microscope 2 is an electron gun using thermionic emission. However, the transmission electron microscope 2 may also be a Schottky-type electron gun, a cold cathode field-emission electron gun, or the like. Furthermore, the embodiments described above illustrates the case where a filament is used as the electron source 210. However, the electron source 210 may also be a tungsten single crystal coated with zirconium oxide used in a Schottky-type electron gun, or a tungsten single crystal used in a cold cathode field-emission electron gun.

Furthermore, the charged particle beam system according to the invention is not limited to a transmission electron microscope and may also be, for example, a scanning electron microscope or a focused ion beam system. In other words, the charged particle beam system according to the invention includes a charged particle source unit with a charged particle source that generates a charged particle beam such as an electron beam or an ion beam.

The invention is not limited to the above-described embodiments, and various modifications can be made. For example, the invention includes configurations that are substantially the same as the configurations described in the embodiments. Substantially same configurations mean configurations having the same functions and methods, for example. The invention also includes configurations obtained by replacing non-essential elements of the configurations described in the embodiments with other elements. The invention further includes configurations obtained by adding known art to the configurations described in the embodiments.

## Claims

1. A charged particle beam system comprising:
a chamber;
a charged particle source unit that has a charged particle source;
a supporting member that is provided on a side wall of the chamber and detachably supports the charged particle source unit inside the chamber; and
a chamber door that is provided on the side wall of the chamber for access to an interior of the chamber.

2. The charged particle beam system according to claim 1, wherein
the supporting member extends from the side wall of the chamber toward a center of the chamber, and
the charged particle source unit is pushed into the supporting member from a direction opposite to a direction in which the supporting member extends.

3. The charged particle beam system according to claim 1 or 2, wherein
the supporting member extends from the side wall of the chamber toward the center of the chamber,
the supporting member has a guide that extends in the direction in which the supporting member extends, and
the charged particle source unit has an engaging part that engages with the guide.

4. The charged particle beam system according to any one of claims 1 to 3, wherein
the supporting member extends in a first direction from the side wall of the chamber, and
the chamber door is positioned in the first direction from the supporting member.

5. The charged particle beam system according to any one of claims 2 to 4, wherein
an optical axis of the charged particle source is perpendicular to the direction in which the supporting member extends.

6. The charged particle beam system according to any one of claims 1 to 5, wherein
the supporting member includes an insulator,
the insulator holds a first terminal electrically connected to a power supply,
the charged particle source unit has a second terminal electrically connected to the charged particle source, and
the first terminal and the second terminal are electrically connected by attaching the charged particle source unit to the supporting member.

7. The charged particle beam system according to any one of claims 1 to 6, further comprising:
an optical system that illuminates a sample with a charged particle beam emitted from the charged particle source.

8. The charged particle beam system according to any one of claims 1 to 7, wherein
the charged particle source generates an electron beam.

9. The charged particle beam system according to claim 8, further comprising:
an illumination optical system that illuminates a sample with an electron beam; and
an imaging optical system that forms an image with electrons that have passed through the sample.

10. The charged particle beam system according to claim 9, further comprising:
a housing that houses an electron optical column and the chamber, wherein
the electron optical column houses the illumination optical system and the imaging optical system, and
a side surface of the housing has a housing door that is provided for access to the chamber door.

11. A replacement method for a charged particle source unit in a charged particle beam system that includes:
a chamber;
a charged particle source unit that has a charged particle source;
a supporting member that is provided on a side wall of the chamber and detachably supports the charged particle source unit inside the chamber; and
a chamber door that is provided on the side wall of the chamber for access to an interior of the chamber,
the replacement method comprising:
opening the chamber door;
removing a first charged particle source unit from the supporting member; and
introducing a second charged particle source unit into the chamber through the chamber door and attaching the second charged particle source unit to the supporting member.

12. The replacement method for the charged particle source unit according to claim 11, wherein
the removing of the first charged particle source unit involves
attaching a jig to the first charged particle source unit supported by the supporting member, and
removing the first charged particle source unit from the supporting member, with the jig being gripped.

13. The replacement method for the charged particle source unit according to claim 12, wherein
the jig includes
an electrode, and
wiring that electrically connects the first charged particle source unit and the electrode, and
the removing of the first charged particle source unit involves electrically connecting the first charged particle source unit and the electrode through the wiring and bringing the electrode into contact with the chamber.

14. The replacement method for the charged particle source unit according to any one of claims 11 to 13, wherein
the supporting member extends from the side wall of the chamber toward a center of the chamber, and
the attaching of the second charged particle source unit to the supporting member involves pushing the second charged particle source unit into the supporting member in a direction opposite to a direction in which the supporting member extends.

15. The replacement method for the charged particle source unit according to any one of claims 11 to 14, wherein
the charged particle beam system includes a housing that houses an electron optical column and the chamber,
a side surface of the housing has a housing door that is provided for access to the chamber door, and
the replacement method further comprises opening the housing door prior to the opening of the chamber door.
